# EUROPEAN PATENT APPLICATION

(11) **EP 2 833 417 A1**
(43) Date of publication of application: **04.02.2015**
(21) Application number: 12872712.0
(22) Date of filing: 27.03.2012
(51) Int. Cl.: H01L 31/048

(54) **SOLAR CELL MODULE SEALING FILM, AND SOLAR CELL MODULE USING SAME**

(71) Applicant: C. I. Kasei Company, Limited, Tokyo 104-8321 (JP)
(72) Inventor: MIYOSHI Masanao, Tokyo 104-8321 (JP); SUGIYAMA Hitoshi, Tokyo 104-8321 (JP); KAWABE Junya, Tokyo 104-8321 (JP); HIRANO Tatsuya, Tokyo 104-8321 (JP)
(74) Representative: Treeby, Philip David William
(86) International application number: PCT/JP2012/057873
(87) International publication number: WO 2013/145116

(57) **Abstract**

The present invention provides a solar cell module sealing film (12, 14) including a pair of sealing films (12, 14) which seals a photovoltaic element (13) including a first film (12) disposed on a surface of the photovoltaic element (13), and a second film (14) disposed on a back surface of the photovoltaic element, in which transmittance of light having a wavelength of 350 nm in the first film (12) is greater than or equal to 80%, and an ultraviolet ray absorber is contained in at least one of the first film (12) and the second film (14).

## Description

### Technical Field

The present invention relates to a solar cell module sealing film, and a solar cell module using the same.

### Background Art

In the related art, as energy for replacing fossil fuels, solar energy has been focused on. In particular, a solar cell module which is manufactured in order to use solar energy has been rapidly spread in various fields recently.

In general, the solar cell module is integrally manufactured by laminating a glass substrate, an upper surface sealing film, a photovoltaic element (for example, a silicon power generation element), a lower surface sealing film, and a back surface sheet in sequence, and by adhering the laminated films to each other by heating and pressing.

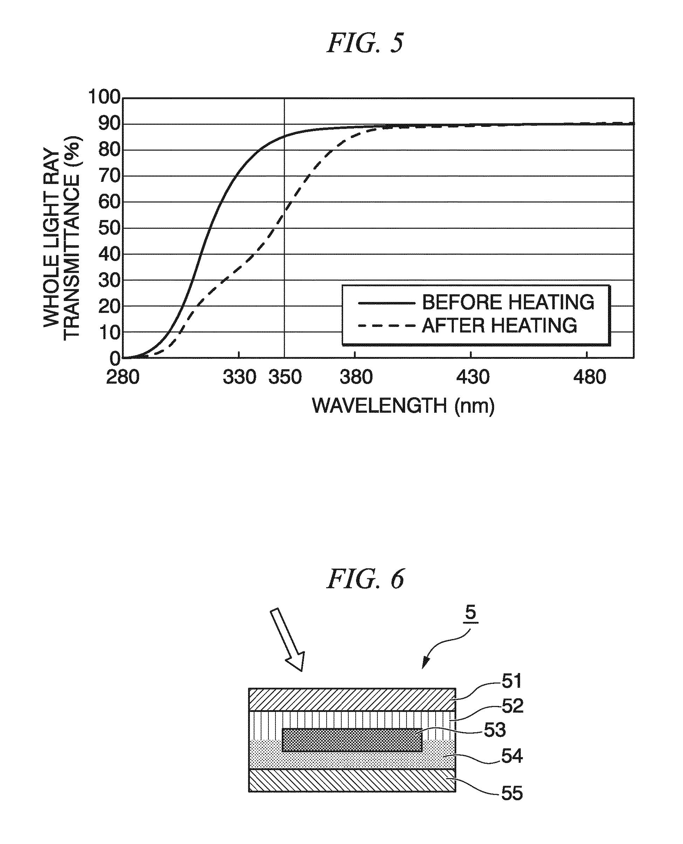

FIG. 6 is a cross-sectional view of a general solar cell module 5. As illustrated in FIG. 6, when a surface on which solar light (an arrow in FIG. 6) is received is an uppermost surface, the general solar cell module 5 includes a glass substrate 51, an upper surface sealing film 52, a photovoltaic element 53, a lower surface sealing film 54, and a back surface sheet (referred to as a "back sheet") 55 in a sequence from the uppermost surface.

Each of the sealing films (for example, the upper surface sealing film 52 or the lower surface sealing film 54 in FIG. 6) in such a solar cell module 5 is necessary for covering the photovoltaic element 53, for protecting the element against a severe external environment such as temperature change, humidity, and impact, and for securing adhesiveness with respect to the glass substrate 51 or the back surface sheet 55. Accordingly, for each of the sealing films of such a solar cell module 5, transparency, weatherability, heat resistance, adhesiveness, or the like is required. In order to satisfy the requirement, each of the sealing films is blended with a cross-linking agent, a cross-linking assistant, a coupling agent, an ultraviolet ray absorber, a light stabilizer, an antioxidant, or the like.

For example, as disclosed in Patent Document 1, in order to improve the weatherability of the sealing film or the back surface sheet, in the sealing film (for example, the upper surface sealing film 52 or the lower surface sealing film 54 in FIG. 6), an ultraviolet ray absorber which is composed of various organic compounds such as a salicylic acid-based compound, a benzophenone-based compound, a benzotriazole-based compound, and a cyanoacrylate-based compound is contained.

### Citation List

### Patent Documents

Patent Documents: Japanese Unexamined Patent Application, First Publication No. H11-317475

### Summary of Invention

### Technical Problem

However, recently, in order to improve power generation efficiency of the photovoltaic element in the solar cell module, a finding in which the power generation efficiency of the photovoltaic element is able to be improved by receiving light in an ultraviolet region (approximately 300 nm to 400 nm) has been obtained. For this reason, in order to improve the power generation efficiency of the photovoltaic element, it is necessary that the ultraviolet ray absorber which has been added not be added to the sealing film (for example, the upper surface sealing film 52 or the lower surface sealing film 54 in FIG. 6) close to the uppermost surface.

However, when the ultraviolet ray absorber is not added to the sealing film (for example, the upper surface sealing film 52 or the lower surface sealing film 54 in FIG. 6), the back surface sheet 55 may be degraded (yellowed) by ultraviolet rays. In the solar cell module 5, the back surface sheet 55 is disposed in order to protect the solar cell module 5 against impact or the like. That is, when the back surface sheet 55 is degraded, impact resistance, water resistance, or the like of the solar cell module 5 decreases.

On the other hand, in the solar cell module 5 illustrated in FIG. 6, for example, adding the ultraviolet ray absorber only to the lower surface sealing film 54 is considered. However, even if the ultraviolet ray absorber is added only to the lower surface sealing film 54, according to an actual use environment of the solar cell module 5, the ultraviolet ray absorber added to the lower surface sealing film 54 passes through, for example, a gap between the photovoltaic elements 53, and is gradually moved to the upper surface sealing film 52.

That is, in order to improve the power generation efficiency of the photovoltaic element 53 in the solar cell module 5, even though the ultraviolet ray absorber is not added to the sealing film (the upper surface sealing film 52) close to the uppermost surface, the sealing film (the upper surface sealing film 52) is in a state where the ultraviolet ray absorber is added. As a result, the photovoltaic element 53 is not able to receive the light in the ultraviolet region (approximately 300 nm to 400 nm), and thus the power generation efficiency of the photovoltaic element 53 decreases over time.

The present invention has been made in view of the problems described above, and is to provide a solar cell module sealing film in which, even when an ultraviolet ray absorber is added to any one of a pair of films for sealing a photovoltaic element, it is difficult for the ultraviolet ray absorber to be moved to the other film under an actual use condition, and a solar cell module using the same.

### Solution to Problem

According to a first aspect of the present invention, a solar cell module sealing film includes a pair of sealing films which seals a photovoltaic element including a first film disposed on a surface of the photovoltaic element, and a second film disposed on a back surface of the photovoltaic element. In addition, transmittance of light having a wavelength of 350 nm in the first film is greater than or equal to 80%, and an ultraviolet ray absorber is contained in at least one of the first film and the second film. In addition, a transmittance attenuation rate of the first film at the time of performing a test by the following testing methods (1) to (5) described below is less than or equal to 10%. Hereinafter, the testing methods (1) to (5), that is, a calculation method of the transmittance attenuation rate, will be described.

### <Testing Method>

(1) A test plate is obtained by making the first film having a thickness of 0.5 mm, a length of 50 mm, and a width of 50 mm, and the second film having a thickness of 0.5 mm, a length of 50 mm, and a width of 50 mm be in contact with each other in a width direction, and by sandwiching the first film and the second film by two glass plates having a thickness of 0.5 mm, a length of 50 mm, and a width of 50 mm. Furthermore, as the glass plate, from a point of light permeability, a white glass plate (high permeable glass) having a low content of iron is preferably used. In addition, a glass template having a concavity and a convexity on a surface thereof is preferably used.
(2) The transmittance of the light having the wavelength of 350 nm in a portion of 5 mm in a direction of the first film from a seam between the first film and the second film in the test plate (a portion having a measurement area in the shape of a quadrangle of 10 mm in width × 5 mm in length) is measured.
(3) The test plate is heated at 85°C for 14 days.
(4) The transmittance in the test plate is measured by using the same method as (2).
(5) The transmittance in (4) at the time of setting the transmittance in (2) to 100 is set to the transmittance attenuation rate.

According to a second aspect of the present invention, in the solar cell module sealing film according to the first aspect, the ultraviolet ray absorber is contained only in the second film.

According to a third aspect of the present invention, in the solar cell module sealing film according to the first aspect, molecular weight of the ultraviolet ray absorber is greater than or equal to 1000.

According to a fourth aspect of the present invention, in the solar cell module sealing film according to the first aspect, the second film includes an ethylene-vinyl acetate copolymer resin (an EVA resin), and contains the ultraviolet ray absorber of 0.01 mass% to 2 mass% with respect to the ethylene-vinyl acetate copolymer resin.

According to a fifth aspect of the present invention, a solar cell module is sealed with a photovoltaic element by the solar cell module sealing film according to any one of the first to fourth aspects.

### Advantageous Effects of Invention

According to the present invention, it is possible to provide a solar cell module sealing film in which, even when the ultraviolet ray absorber is added to any one of the pair of films for sealing the photovoltaic element, it is difficult for the ultraviolet ray absorber to be moved to the other film under an actual use condition, and a solar cell module using the same.

### Brief Description of Drawings

FIG. 1 is a diagram illustrating a cross section of a solar cell module using a solar cell module sealing film according to one embodiment of the present invention.
FIG. 2A is a diagram illustrating a test plate 3.
FIG. 2B is a diagram illustrating the test plate 3.
FIG. 3 is a diagram illustrating a measurement region of the test plate 3 in which transmittance of light in an ultraviolet region is measured.
FIG. 4 is a diagram (Example) illustrating the transmittance of the light in the test plate.
FIG. 5 is a diagram (Comparative Example) illustrating the transmittance of the light in the test plate.
FIG. 6 is a diagram for describing a general solar cell module.

### Description of Embodiments

Hereinafter, a solar cell module sealing film, and a solar cell module using the same according to one embodiment of the present invention will be described with reference to the drawings.

A configuration of the solar cell module using the solar cell module sealing film according to one embodiment of the present invention will be described. Furthermore, in the following description, the solar cell module using the solar cell module sealing film according to one embodiment of the present invention will be simply referred to as a "solar cell module 1".

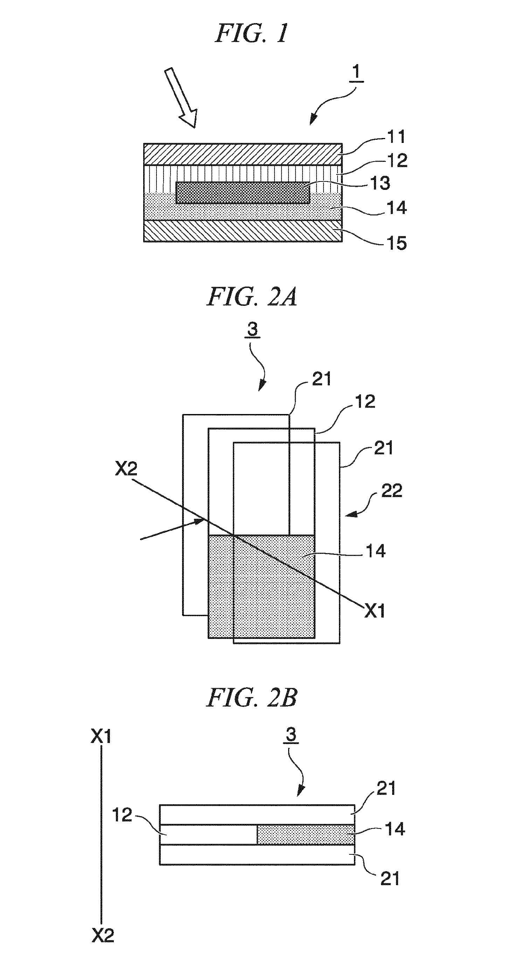

FIG. 1 is a diagram illustrating a cross section of the solar cell module 1.

Specifically, FIG. 1 is a cross-sectional view of the solar cell module 1. As illustrated in FIG. 1, when a surface on which solar light (an arrow in FIG. 1) is received is an uppermost surface, the solar cell module 1 includes a glass substrate 11, a first film 12, a photovoltaic element 13, a second film 14, and a back surface sheet (also referred to as a "back sheet") 15, in a sequence from the uppermost surface. Furthermore, a thickness of the glass substrate 11 is approximately 3 mm to 4 mm, a thickness of the first film 12 is approximately 0.5 mm, a thickness of the photovoltaic element 13 is approximately 0.2 mm, a thickness of the second film 14 is approximately 0.5 mm, and a thickness of the back surface sheet 15 is approximately 0.3 mm.

The configuration of the solar cell module 1 is as described above.

Through intensive studies, the inventors of the present invention have manufactured the solar cell module 1 in which, even when an ultraviolet ray absorber is added to the second film 14, it is difficult for the ultraviolet ray absorber added to the second film 14 to be moved to the first film 12 under a condition of estimating an actual use environment of the solar cell module 1.

Hereinafter, the present invention will be described in detail, but the description does not limit the present invention. Accordingly, various changes and modifications may be made with respect to the present invention without departing from the scope of the present invention.

First, the glass substrate 11, the photovoltaic element 13, and the back surface sheet 15 of FIG. 1 will be described. Next, the first film 12 and the second film 14 of FIG. 1 will be described.

The glass substrate 11 of FIG. 1 is a flat substrate made of glass to which functionality is industrially added. The glass substrate 11, for example, includes a soda-lime glass-based substrate, an alkali-free glass-based substrate, and the like which are classified according to a composition of the glass, and may be used as a general glass plate which is used for a flat display (FPD) such as a liquid crystal television (LCD), a plasma television (PDP), and a laptop, an organic EL, or the like. In addition, as the glass substrate 11, a transparent resin or the like may be used instead of the glass plate described above. In addition, as the glass substrate 11, from a point of light permeability, a white glass plate (high permeable glass) having a low content of iron, and a glass template having a concavity and a convexity on a surface thereof are preferably used.

The photovoltaic element 13 of FIG. 1 is a portion for performing photoelectric conversion by receiving the solar light. As the photovoltaic element 13, known elements used for a general solar cell module may be variously selected. For example, as an example of the photovoltaic element 13, single crystal silicon such as CIGS (chemical formula: CuInₓGa₍₁₋ₓ₎Se₂), pn junction type polycrystalline silicon, pin junction type amorphous silicon, a compound semiconductor such as CuInSe₂, CuInS₂, GaAs, CdS/Cu₂S, CdS/CdTe, CdS/InP, CdTe/Cu₂Te, and the like are included.

As the back surface sheet 15 of FIG. 1, for example, an ethylene-vinyl acetate copolymer (EVA), an ethylene-acrylic acid methyl copolymer (EMA), an ethylene-acrylic acid ethyl copolymer (EEA), a polyester-based resin, or the like is used. In general, a polyolefin-based resin represented by a polyethylene-based resin, a silicon-based resin, a fluorocarbon-based resin, or the like is included. Among these, the polyester-based resin or the fluorocarbon-based resin is preferably used. Further, when the back surface sheet 15 is a laminated sheet in which metal such as aluminum foil, and inorganic metal compounds such as silica, alumina, and silicon nitride are laminated, it is possible to further raise a gas barrier, and thus is preferable. Furthermore, the back surface sheet 15 may be a glass plate or the like.

Next, the solar cell module sealing film according to one embodiment of the present invention, that is, the first film 12 and the second film 14, will be described with reference to FIG. 1.

As illustrated in FIG. 1, the solar cell module 1 includes the glass substrate 11, the first film 12, the photovoltaic element 13, the second film 14, and the back surface sheet 15. The solar cell module 1, for example, is manufactured by sequentially laminating the sheet-like first film 12, the photovoltaic element 13, the sheet-like second film 14, and the back surface sheet 15 on the glass substrate 11, and by performing heating and pressing (for example, a vacuum heating and pressing method).

Next, the first film 12 and the second film 14 will be described in more detail. Furthermore, the photovoltaic element 13 is described above, and thus the description thereof will be omitted.

The first film 12, for example, is formed to be a sheet-like film having a thickness of approximately 0.5 mm by a T-die method by mainly using a low density polyethylene-based resin, a linear low density polyethylene-based resin, or a polyolefin-based resin such as an ethylene-vinyl acetate copolymer resin (a so-called EVA resin, hereinafter, referred to as the "EVA resin"). Furthermore, as described above, the first film 12 is formed by mainly using the polyolefin-based resin (for example, a polyvinylbutyral resin, an ionomer resin, or the like), and among the polyolefin-based resin, it is particularly preferable that the EVA resin in which a content of vinyl acetate is approximately 15% to 40% be used. Furthermore, the first film 12 may be suitably blended with additives such as a cross-linking agent, a plasticizer, a heat stabilizer, an antioxidant, a antistatic agent, pigment, and dye, as necessary, but it is preferable that an ultraviolet ray absorber not be added.

Similar to the first film 12, the second film 14, for example, is formed to be a sheet-like film having a thickness of approximately 0.5 mm by the T-die method by mainly using the low density polyethylene-based resin, the linear low density polyethylene-based resin, or the polyolefin-based resin such as the EVA resin. In addition, the second film 14 is also formed by mainly using the polyolefin-based resin, and among the polyolefin-based resin (for example, the polyvinylbutyral resin, the ionomer resin, or the like), it is particularly preferable that the EVA resin in which a content of vinyl acetate is approximately 15% to 40% be used.

Furthermore, the second film 14 may be suitably blended with the additives such as the cross-linking agent, the plasticizer, the heat stabilizer, the antioxidant, the antistatic agent, the pigment, and the dye, as necessary. However, it is preferable that the ultraviolet ray absorber be added to the second film 14 as essential additives, unlike in the first film 12.

Hereinafter, the ultraviolet ray absorber which is preferably added to the second film 14 will be described. The ultraviolet ray absorber added to the second film 14 is a polymer type ultraviolet ray absorber in which weight average molecular weight in terms of polystyrene by a gel permeation chromatography (GPC) is greater than or equal to 1000. Preferably, the weight average molecular weight in terms of polystyrene is greater than or equal to 5000, and more preferably, is greater than or equal to 10000.

In addition, as the polymer type ultraviolet ray absorber added to the second film 14, for example, a product name of ULS-935LH, ULS-700, ULS-635L, ULS-1935LH, ULS-1700, ULS-1635, or the like produced by Ipposha Oil Industries Co. Ltd., and a product name of RUVA-93 or the like produced by Otsuka Chemical Co., Ltd. are preferably used.

In addition, as the ultraviolet ray absorber added to the second film 14 in addition to each organic compound described above, each organic compound such as a salicylate-based compound, a benzophenone-based compound, a benzotriazole-based compound, a benzoate-based compound, and a cyanoacrylate-based compound is included. Among these, in particular, 2,2'-dihydroxy-4-4'-dimethoxy benzophenone, 2,4-dihydroxy benzophenone, 2 (2'-hydroxy-5'-methylphenyl) benzotriazole, 2 (2'-hydroxy-3',5'-di-tert-butylphenyl) benzotriazole, 2 (2-hydroxy-3'-tert-butyl-5'-methylphenyl)-5-chlorobenzotriazole, 2 (2-hydroxy-3',5'-di-tert-butylphenyl)-5-chlorobenzotriazole, or the like are included. In addition, the inorganic-based ultraviolet ray absorber such as metal complex (for example, [2,2'-thiobis (4-tert-octyl phenolate)]-n-butylamine nickel, nickel bis [O-ethyl (3,5-di-tert-butyl-4-hydroxybenzyl)] phosphonate, or the like), ultrafine titanium oxide, or ultrafine zinc oxide is also able to be used within an amount by which movement to the first film is able to be ignored.

Furthermore, when the second film 14 is a film formed of the EVA resin, the ultraviolet ray absorber added to the second film 14, for example, is 0.01 mass% to 2 mass%, and preferably is 0.1 mass% to 1.4 mass% with respect to the EVA resin.

### [Example]

Hereinafter, on the basis of Example and Comparative Example, the present invention will be described in more detail. Here, the present invention is not limited to Example described below, but a combination or a blending amount of a composition of each contained component may be changed within a qualitative range and a quantitative range without impairing the effects of the present invention.

As described above, in a relationship between the first film 12 and the second film 14 of the solar cell module 1 as illustrated in FIG. 1, the present invention, for example, provides the first film 12 and the second film 14 in which it is difficult for the ultraviolet ray absorber added to the second film 14 to be moved to the first film 12 under the condition of estimating the actual use environment of the solar cell module 1 even when the ultraviolet ray absorber is added to the second film 14.

Therefore, the applicant confirmed that it is difficult for the ultraviolet ray absorber added to the second film 14 to be moved to the first film 12 under the condition of estimating the actual use environment of the solar cell module 1 by the following test, as Example.

In addition, the applicant added an ultraviolet ray absorber which is different from the ultraviolet ray absorber added to the second film 14 to the second film 14, and performed the same test, as Comparative Example, and the details will be described later.

### (Example)

### (Test Plate)

First, as illustrated in FIGS. 2A and 2B, the test plate 3 was manufactured. Specifically, as illustrated in FIG. 2A, the test plate 3 includes a glass plate 21 (specifically, may be identical to the glass substrate 11 of FIG. 1), a test film 22, and a glass plate 21 (specifically, may be identical to the glass substrate 11 of FIG. 1), in a sequence from X2 toward X1. In other words, the test film 22 is sandwiched by two transparent glass plates 21. Then, after sandwiching the test film 22 by the glass plates 21, a hot plate temperature was set to 150°C in a vacuum heating apparatus, and the test film 22 sandwiched by the glass plates 21 was left in a vacuum state for 5 minutes. Subsequently, it was pressed for 10 minutes, and the test plate 3 was manufactured as illustrated in FIG. 2B.

Furthermore, as the glass plate 21, a glass plate having a thickness of 3.9 mm, a length of 100 mm, and a width of 50 mm was used.

### (Test Film)

As illustrated in FIG. 2B, the test film 22 is configured in a state where the first film 12 and the second film 14 come into contact with each other in a width direction. As described above, the test plate is configured by sandwiching the test film 22 by the two glass plates 21. Furthermore, the first film 12 and the second film 14 were respectively prepared, specifically, by the following manufacturing methods.

First Film: 100 parts by mass of an ethylene-vinyl acetate copolymer (a content of vinyl acetate at 28%, MFR 20g/10 minutes, and a melting point at 71 °C), and 1.0 parts by mass of a cross-linking agent (t-butyl peroxy-2-ethyl hexyl carbonate) were dry-blended by a ribbon blender, and were subjected to melting and kneading by an extruder (uniaxial, a diameter of 90 mm), and thus a film having a thickness of 0.5 mm was obtained by an extrusion molding method using a T-die. A temperature of the T-die was 90°C, and a rotation speed of a screw was 20 rpm. A film having a length of 50 mm and a width of 50 mm was taken from the film. The taken film was a first film for the test film 22.

Second Film: a second film for the test film 22 was obtained by the same method as that of the first film, except that 0.4 parts by mass of ultraviolet ray absorber (a product name of ULS-635L produced by Ipposha Oil Industries Co. Ltd.; an acrylic copolymer which includes a skeleton (benzophenone-based) having ultraviolet rays absorbent in a side chain, and weight average molecular weight in terms of polystyrene by a gel permeation chromatography (GPC) being approximately 20000) was added to the composition of the first film.

### (Movement Ratio of Ultraviolet Ray Absorber)

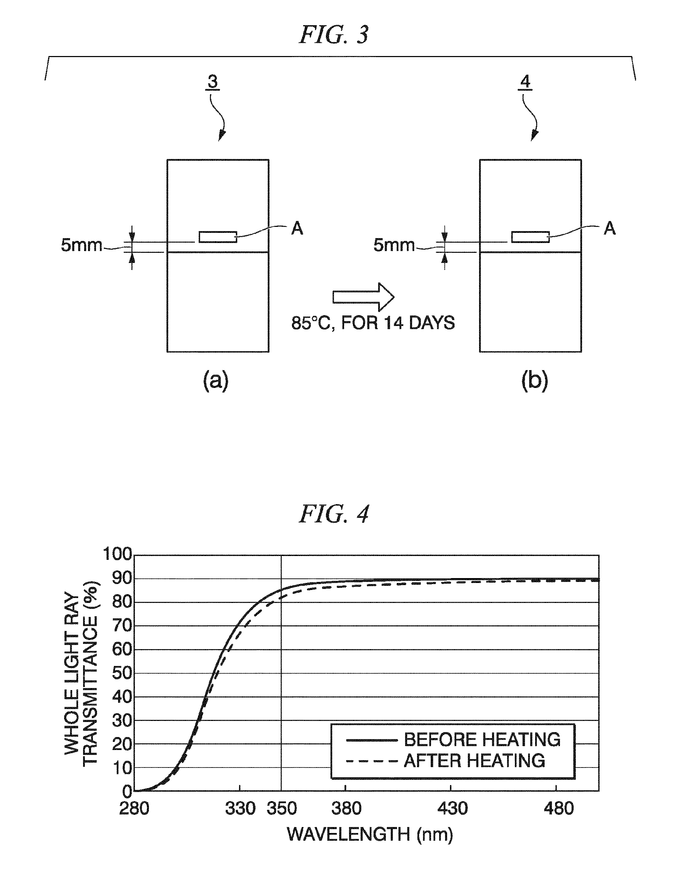

The test plate 3 illustrated in FIGS. 2A and 2B was heated at 85°C for 14 days, and in the test film 22, how far the ultraviolet ray absorber contained in the second film 14 had been moved to the first film 12 was investigated. Specifically, first, in the test plate (before heating) 3 before being heated at 85°C for 14 days as illustrated in (a) of FIG. 3, transmittance of light in an ultraviolet region in a portion of 5 mm in a direction of the first film 12 from a seam between the first film 12 and the second film 14 (a portion indicated by A in (a) of FIG. 3, and a portion having a measurement area in the shape of a quadrangle of 10 mm in width × 5 mm in length) was measured.

Then, in the test plate (after heating) 4 after being heated at 85°C for 14 days illustrated in (b) of FIG. 3, similarly, transmittance of light in an ultraviolet region in a portion indicated by A in (b) of FIG. 3 was measured. Furthermore, the transmittance of the light in the ultraviolet region was measured by using the following measuring instrument.

### Measuring Instrument: an ultraviolet-visible ray spectrophotometer produced by JASCO Corporation (Item Number: V-570)

A measurement result thereof is illustrated in FIG. 4. In FIG. 4, a solid line indicates the transmittance of the light in the test plate 3 before the heating, and a dashed line indicates the transmittance of the light in the test plate 4 after the heating.

First, as described above, the first film 12 of the test film 22 is not blended with the ultraviolet ray absorber, and thus the solid line of FIG. 4 is considered as a reference of a movement ratio of the ultraviolet ray absorber. That is, when the ultraviolet ray absorber added to the second film 14 is moved to the first film 12, attenuation of the transmittance is observed compared to the solid line of FIG. 4. In contrast, when the ultraviolet ray absorber added to the second film 14 is not moved to the first film 12, approximately the same curve as the solid line of FIG. 4 is obtained.

Here, when the first film 12 and the second film 14 are in incorporated in the solar cell module which is an actual product, and the transmittance of light having a wavelength of 350 nm in the solid line of FIG. 4 is set to 100, the transmittance after being heated at 85°C for 14 days is set to be greater than or equal to 91.5 as a reference for withstanding actual use. That is, an acceptable amount when the ultraviolet ray absorber added to the second film 14 is moved to the first film 12 is set.

As a result, as illustrated by the dashed line in FIG. 4, the transmittance in the test film 22 according to this Example was 97, and it was confirmed that the transmittance satisfied the reference.

### (Comparative Example)

Next, a second film in which the ultraviolet ray absorber different from Example described above was added to the second film 14 was manufactured, and the same measurement was performed. Specifically, the second film of Comparative Example was prepared by the following manufacturing method.

Second Film: a second film for the test film 22 was obtained by the same method as that of the first film, except that 0.4 parts by mass of an ultraviolet ray absorber (SEESORB151 produced by Shipro Kasei Kaisha, LTD.; 1,4-bis(4-benzoyl-3-hydroxyphenoxy)-butane, and molecular weight of 482.5) was added to the composition of the first film.

Furthermore, Comparative Example is identical to Example described above, except that the ultraviolet ray absorber added to the second film 14 is different, and thus the description will be omitted.

A measurement result of the transmittance is illustrated in FIG. 5. Furthermore, in FIG. 5, a solid line indicates the transmittance before the heating, and a dashed line indicates the transmittance after the heating. As illustrated by the dashed line of FIG. 5, when the transmittance of the light having a wavelength of 350 nm in the solid line of FIG. 5 was set to 100, the transmittance was attenuated to 65 after the heating, and it was confirmed that the transmittance did not satisfy the reference which was greater than or equal to 91.5.

As described above, it was confirmed that a polymer type absorber of which weight average molecular weight was greater than or equal to 1000 was preferably used as the ultraviolet ray absorber added to the second film 14. That is, with reference to FIG. 1 again, when the ultraviolet ray absorber of which a melting point is higher than or equal to 70°C, and more preferably is higher than or equal to 120°C is added to the second film 14, it is possible to obtain excellent effects. That is, even in the actual use environment of the solar cell module 1, it is possible to prevent the ultraviolet ray absorber added to the second film 14 from passing through, for example, a gap between the photovoltaic elements 13 to be gradually moved to the first film 12. Further, it is possible to prevent the back surface sheet 15 from being degraded (yellowed) by the ultraviolet rays.

As a result, the photovoltaic element 13 is able to receive the light in the ultraviolet region (approximately 300 nm to 400 nm), and power generation efficiency is able to be improved.

### Industrial Applicability

The solar cell module sealing film, and the solar cell module using the same according to the present invention, for example, are able to be usefully applied to a solar panel or the like which is used for power sources of various electronic apparatuses requiring electric power, solar light power generation, or the like.

### Reference Signs List

1, 5: solar cell module
11, 51: glass substrate
12: first film
13, 53: photovoltaic element
14: second film
15, 55: back surface sheet
21: glass plate
22: test film
3, 4: test plate
52: upper surface sealing film
54: lower surface sealing film

## Claims

1. A solar cell module sealing film, comprising:
a pair of sealing films which seals a photovoltaic element including a first film disposed on a surface of the photovoltaic element, and a second film disposed on a back surface of the photovoltaic element,
wherein transmittance of light having a wavelength of 350 nm in the first film is greater than or equal to 80%,
an ultraviolet ray absorber is contained in at least one of the first film and the second film, and
a transmittance attenuation rate of the first film at the time of performing a test by the following testing methods (1) to (5) is less than or equal to 10%,
<Testing Methods>
(1) obtaining a test plate by making the first film having a thickness of 0.5 mm, a length of 50 mm, and a width of 50 mm, and the second film having a thickness of 0.5 mm, a length of 50 mm, and a width of 50 mm be in contact with each other in a width direction, and by sandwiching the first film and the second film by two glass plates having a thickness of 0.5 mm, a length of 50 mm, and a width of 50 mm,
(2) measuring the transmittance of the light having the wavelength of 350 nm in a portion of 5 mm in a direction of the first film from a seam between the first film and the second film in the test plate (a portion having a measurement area in the shape of a quadrangle of 10 mm in width × 5 mm in length),
(3) heating the test plate at 85°C for 14 days,
(4) measuring the transmittance in the test plate by using the same method as (2), and
(5) setting the transmittance in (4) at the time of setting the transmittance in (2) to 100 to the transmittance attenuation rate.

2. The solar cell module sealing film according to Claim 1,
wherein the ultraviolet ray absorber is contained only in the second film.

3. The solar cell module sealing film according to Claim 1,
wherein molecular weight of the ultraviolet ray absorber is greater than or equal to 1000.

4. The solar cell module sealing film according to Claim 1,
wherein the second film includes an ethylene-vinyl acetate copolymer resin (an EVA resin), and contains the ultraviolet ray absorber of 0.01 mass% to 2 mass% with respect to the ethylene-vinyl acetate copolymer resin.

5. A solar cell module which is sealed with a photovoltaic element by the solar cell module sealing film according to Claim 1.

6. A solar cell module which is sealed with a photovoltaic element by the solar cell module sealing film according to Claim 2.

7. A solar cell module which is sealed with a photovoltaic element by the solar cell module sealing film according to Claim 3.

8. A solar cell module which is sealed with a photovoltaic element by the solar cell module sealing film according to Claim 4.
